(19) **Europäisches Patentamt** / **European Patent Office** / **Office européen des brevets**

(11) **EP 4 749 860 A1**

(12) **EUROPEAN PATENT APPLICATION**

(43) Date of publication:
27.05.2026 Bulletin 2026/22

(21) Application number: 25217856.1

(22) Date of filing: 21.11.2025

(51) International Patent Classification (IPC):
*H02H 3/28* (2006.01)   *H02H 7/26* (2006.01)
*H02H 1/00* (2006.01)   *H04B 17/00* (2015.01)
*H02H 3/05* (2006.01)

(52) Cooperative Patent Classification (CPC):
**H02H 7/261; H02H 3/05; H02H 3/28; H04B 17/00;**
**H02H 1/0084**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **22.11.2024 US 202418956314**

(71) Applicant: Schweitzer Engineering Laboratories,
Inc.
Pullman, WA 99163 (US)

(72) Inventors:
• **Harmukh, Sajal**
**Pullman, WA, 99163 (US)**
• **Schmidt, David**
**Athens, GA (US)**
• **Agyekum, Fred**
**Indian Trail, NC (US)**
• **Fischer, Normann**
**Colfax, WA (US)**

(74) Representative: **Smith, Jeremy Robert**
**Kilburn & Strode LLP**
**Lacon London**
**84 Theobalds Road**
**London WC1X 8NL (GB)**

(54) **SYSTEMS AND METHODS FOR CHANNEL ASYMMETRY ESTIMATION AND EVALUATION**

(57)     A system includes a first intelligent electronic device (IED) (202) of an electric power delivery system (200). The first IED (202) may measure a local current and a local voltage (206), transmit a first signal indicative of the local current and voltage measurements to additional IEDs (204) via one or more communication channels, receive one or more additional signals indicative of remote current and voltage measurements (210) from each of the additional IEDs (206), determine a respective asymmetry of each of the communication channels based on the local current and voltage measurements (206) and the remote current and voltage measurements (210), determine a total asymmetry based on the respective asymmetries, compare the total asymmetry to one or more threshold relationships between operating currents and restraining currents, each of the one or more threshold relationships comprising a slope value, and perform a control function based on the comparison.

FIG. 4

EP 4 749 860 A1

**Description**

## BACKGROUND

This disclosure relates to systems and methods for analyzing communication channels of a power system. More particularly, this disclosure relates to estimating and evaluating asymmetry in communication channels of a power system.

Electric power delivery systems carry electricity from a transmission system to residential communities, factories, industrial areas, and other electricity consumers. An electric power delivery system may include various intelligent electronic devices (IEDs) that may communicate with other devices of the electric power delivery system during operation of the electric power delivery system. For example, IEDs may exchange signals and/or data in order to perform a control function, such as to control a circuit breaker in response to electrical measurements of the electric power distribution system. However, protection functions implemented by the IEDs, such as line current differential protection, may be impacted by degradation of communication channels between the IEDs, time synchronization challenges, and the like.

## BRIEF DESCRIPTION OF THE DRAWINGS

FIG. 1 is a schematic diagram of an electric power delivery system;

FIG. 2 is a block diagram illustrating an operation to exchange current and voltage measurements between IEDs of an electric power delivery system;

FIG. 3 is a block diagram illustrating an operation to exchange current and voltage measurements between IEDs of an electric power delivery system via multiplexers and a network;

FIG. 4 is a block diagram illustrating an electric power delivery system in which some communications are redirected;

FIG. 5 is a block diagram illustrating an electric power delivery system in which multiple IEDs communicate;

FIG. 6 is a graphical illustration of threshold relationships between operational currents and restraining currents of an IED performing a current differential evaluation for a component of an electric power delivery system using data received from a separate IED or IEDs; and

FIG. 7 is a flowchart of a method for evaluating channel asymmetry between IEDs of an electric power delivery system and performing control functions in response.

## DETAILED DESCRIPTION

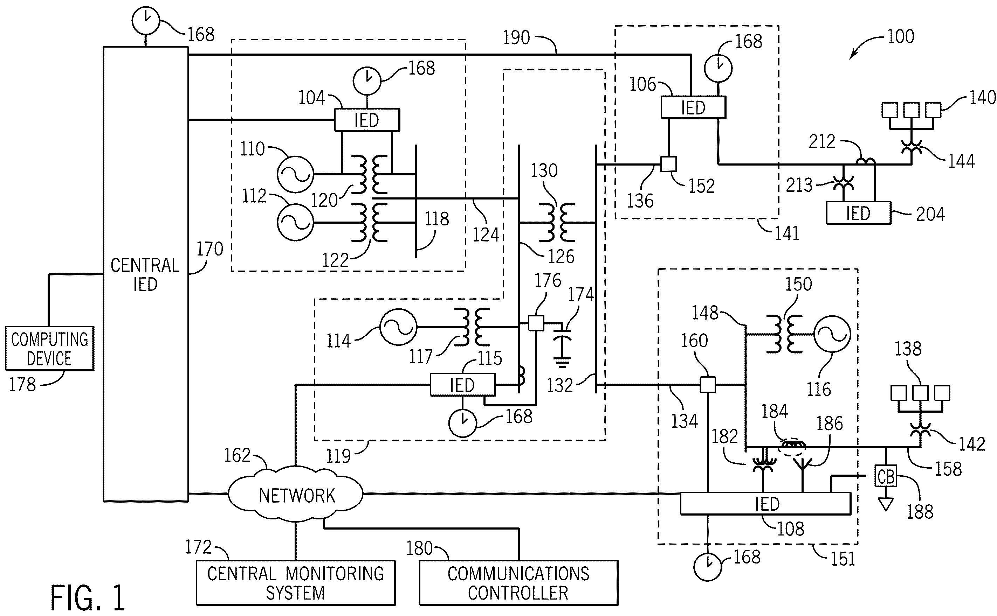

Turning to the drawings, FIG. 1 is a schematic diagram of an electric power delivery system 100 that may generate, transmit, and/or distribute electric energy to various loads (e.g., different structures). The electric power delivery system 100 may use various IEDs 104, 106, 108, 115, 204 to control certain aspects of the electric power delivery system 100. As used herein, an IED (e.g., the IEDs 104, 106, 108, 115, 204) may refer to any processing-based device that monitors, controls, automates, and/or protects monitored equipment within the electric power delivery system 100. Although the present disclosure primarily discusses the IEDs 104, 106, 108, 115, 204 as relays, such as a remote terminal unit, a differential relay, a distance relay, a directional relay, a feeder relay, an overcurrent relay, a voltage regulator control, a voltage relay, a breaker failure relay, a generator relay, and/or a motor relay, additional IEDs 104, 106, 108, 115, 204 may include an automation controller, a bay controller, a meter, a recloser controller, a communications processor, a computing platform, a programmable logic controller (PLC), a programmable automation controller, an input and output module, and the like. Moreover, the term IED may be used to describe an individual IED or a system including multiple IEDs.

For example, the electric power delivery system 100 may be monitored, controlled, automated, and/or protected using the IEDs 104, 106, 108, 115, 204 and a central monitoring system 172 (e.g., an industrial control system). In general, the IEDs 104, 106, 108, 115, 204 may be used for protection, control, automation, and/or monitoring of equipment in the electric power delivery system 100. For example, the IEDs 104, 106, 108, 115, 204 may be used to monitor equipment of many types, including electric power lines, current sensors, busses, switches, circuit breakers, reclosers, transformers, autotransformers, tap changers, voltage regulators, capacitor banks, generators, motors, pumps, compressors, valves, and a variety of other suitable types of monitored equipment.

A common time signal may be distributed throughout the electric power delivery system 100. Utilizing a common time source may ensure that IEDs 104, 106, 108, 115, 204 have a synchronized time signal that can be used to generate time synchronized data, such as synchrophasors. In various embodiments, the IEDs 104, 106, 108, 115, 204 may receive a common time signal 168. The time signal may be distributed in the electric power delivery system 100 using a communications network 162 and/or using separate connections to a common time source, such as a Global Navigation Satellite System ("GNSS"), or the like.

The IEDs 104, 106, 108, 115, 204 may be used for controlling various other equipment of the electric power delivery system 100. By way of example, the illustrated electric power delivery system 100 includes electric generators 110, 112, 114, 116, power transformers 117, 120, 122, 130, 142, 144, 150, a potential transformer 213, and a current transformer 212. The electric power delivery system 100 may also include electric power lines 124, 134, 136, 158 and/or busses 118, 126, 132, 148 to transmit and/or deliver power, communications lines 190 to transmit communications, circuit breakers 152, 160, 176 to control flow of power in the electric power delivery system 100, and/or loads 138, 140 to receive the power in and/or from the electric power delivery system 100. A variety of other types of equipment may also be included in electric power delivery system 100, such as a voltage regulator, a capacitor (e.g., a capacitor 174), a potential transformer (e.g., a potential transformer 182), a current sensor (e.g., a wireless current sensor (WCS) 184), an antenna (e.g., an antenna 186), a capacitor banks (e.g., a capacitor bank (CB) 188), and other suitable types of equipment useful in power generation, transmission, and/or distribution.

A substation 119 may include the electric generator 114, which may be a distributed generator and which may be connected to the bus 126 through the power transformer 117 (e.g., a step-up transformer). The bus 126 may be connected to the distribution bus 132 via the power transformer 130 (e.g., a step-down transformer). Various electric power lines 136, 134 may be connected to the distribution bus 132. The electric power line 136 may lead to a substation 141 in which the electric power line 136 is monitored and/or controlled using the IED 106, which may selectively open and close the circuit breaker 152. The load 140 may be fed from the electric power line 136, and the power transformer 144 (e.g., a step-down transformer) in communication with the distribution bus 132 via electric power line 136 may be used to step down a voltage for consumption by the load 140. The power line 136 may also be monitored by the IED 204 connected to the potential transformer 213 and the current transformer 212.

The electric power line 134 may deliver electric power to the bus 148 of the substation 151. The bus 148 may also receive electric power from the distributed electric generator 116 via the power transformer 150. The electric power line 158 may deliver electric power from the bus 148 to the load 138 and may include the power transformer 142 (e.g., a step-down transformer). The circuit breaker 160 may be used to selectively connect the bus 148 to the electric power line 134. The IED 108 may be used to monitor and/or control the circuit breaker 160 as well as the electric power line 158.

According to various embodiments, the central monitoring system 172 may include one or more of a variety of types of systems. For example, the central monitoring system 172 may include a supervisory control and data acquisition (SCADA) system and/or a wide area control and situational awareness (WACSA) system. A central IED 170 may be in communication with the IEDs 104, 106, 108, 115, 204 via the communications line 190. The IEDs 104, 106, 108, 115, 204 may be remote from the central IED 170 and may communicate over various media. For instance, the central IED 170 may be directly in communication with the IEDs 104, 106 and may be in communication with the IEDs 108, 115, 204 via the communications network 162.

The central IED 170 may enable or block data flow between any of the IEDs 104, 106, 108, 115, 204. For example, during operation of the electric power delivery system 100, the IEDs 104, 106, 108, 115, 204 may transmit data with one another to perform various functionalities for the electric power delivery system 100 by initially transmitting the data to the central IED 170. The central IED 170 may receive the data and may subsequently transmit the data to an intended recipient of the data. The central IED 170 may also control data flow between one of the IEDs 104, 106, 108, 115, 204 and another device communicatively coupled to the central IED 170, such as a computing device 178. For instance, the computing device 178 may be a laptop, a mobile phone, a desktop, a tablet, or another suitable device with which a user (e.g., a technician, an operator) may interact. As such, the user may utilize the computing device 178 to receive data, such as operating data, from the electric power delivery system 100 via the central IED 170 and/or to send data, such as a user input, to the electric power delivery system 100 via the central IED 170. Thus, the central IED 170 may enable or block operation of the electric power delivery system 100 via the computing device 178.

A communications controller 180 may interface with equipment in the communications network 162 to create a network (e.g., ethernet, SDN, etc.) that facilitates communication between the central IED 170, the IEDs 104, 106, 108, 115, 204, and/or the central monitoring system 172. In various embodiments, the communications controller 180 may interface with a control plane (not shown) in the communications network 162. Using the control plane, the communications controller 180 may direct the flow of data within the communications network 162. Indeed, the communications controller 180 may communicate with the central IED 170 to instruct the central IED 170 to transmit certain data (e.g., data associated with a certain set of characteristics or information) to a particular destination (e.g., an intended recipient) using flows, matches, and actions defined by the communications controller 180.

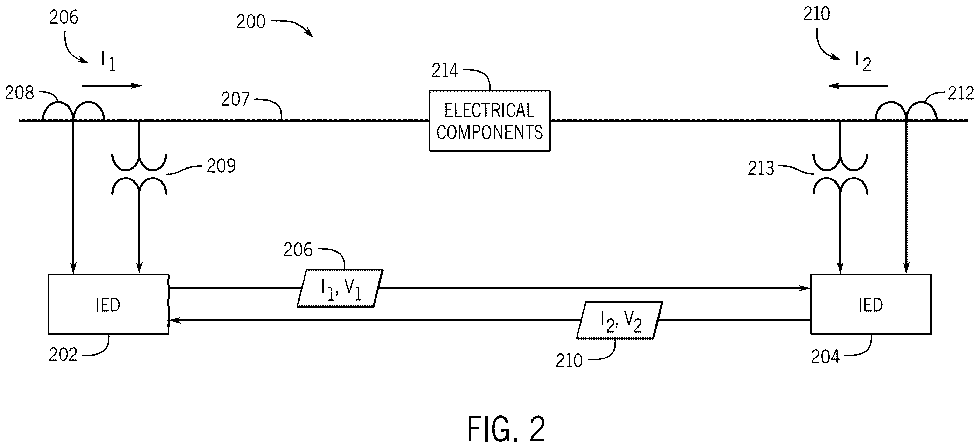

To detect electrical fault conditions within the electric power delivery system 100, IEDs (e.g., the IEDs 104, 106, 108, 115, 204) may exchange and evaluate signals of measured electrical characteristics. FIG. 2 is a block diagram of a line current differential protection (e.g., 87L) system 200 that may be employed with a suitable electric power distribution system, such as the electric power delivery system 100. The line current differential protection system 200 may include IEDs 202 and 204 of FIG. 1, which may additionally or alternatively represent, for example, the IEDs 104, 106, 108, or 115 of FIG. 1. In the illustrated example, the IED 202 may receive first current and voltage measurements 206 of an electrical line 207 from a current transformer 208 and a potential transformer 209, and the IED 204 may receive second current and voltage measurements 210 of the electrical line 207 from a second current transformer 212 and a second potential transformer 213. One or more electrical components 214, which may include electrical loads, may be coupled to the electrical line such that the current transformer 208 and the current transformer 212 may measure a current entering and leaving the one or more electrical components 214.

The IEDs 202 and 204 may, based on the first current measurements 206 and the second current measurements 210, detect a fault condition between the first current transformer 208 and the second current transformer 212 (e.g., within the electrical components 214) or elsewhere along the electrical line 207. In the illustrated example, the IED 202 may receive the first current measurements 206 from the current transformer 208 and the second current measurements 210 from the IED 204 and, likewise, the second IED 204 may receive the second current measurements 210 from the current transformer 212 and the first current measurements 206 from the IED 202. Each of the IEDs 202 and 204 may calculate a vector summation of the first current measurements 206 and the second current measurements 210, which may herein be referred to as an operating current, operational current, or differential current as follows:

$$[1] \qquad I_{op} = |I_1 + I_2|$$

The operating current may indicate whether an electrical fault is present along the electrical line 207 between the current transformer 208 and the current transformer 212. For example, if no fault is present between the current transformer 208 and the current transformer 212, the operating current may be zero. This may indicate that the first current measurements 206 and the second current measurements 210 are balanced (e.g. the current flowing into the electrical line at the current transformer 208 is equal to the current flowing out of the electrical line at the current transformer 212). However, if an electrical fault is present between the current transformer 208 and the current transformer 212, the operating current may be greater than zero (e.g., the first current measurements 206 and the second current measurements 210 are not balanced). In some cases, a difference in magnitude between the first current measurements 206 and the second current measurements 210 may be the result of either or both of the current transformer 208 and the current transformer 212 saturating in response to a high external fault current.

Each of the IEDs 202 and 204 may also calculate a restraining current based on the first current measurements 206 and the second current measurements 210. The restraining current may be calculated as follows:

$$[2] \qquad I_{res} = |I_1| + |I_2|$$

The restraining current and operating current may be used to indicate a fault condition along the electrical line 207. For example, a fault condition along the electrical line 207 may cause the current transformer 208 and/or the current transformer 212 to saturate such that the restraining current decreases. Further, the operating current and restraining current may be compared by the IEDs 202 and 204 to determine a fault condition when the following condition is satisfied:

$$[3] \qquad I_{op} > k * I_{res}$$

where k is an adjustable coefficient. In particular, as will be described in more detail below, the adjustable coefficient k may be adjusted when an external fault condition is detected by the IED 202 and/or the IED 204 IED 204 to prevent unintended operations or interruptions to electrical line 207. Similarly, the coefficient k may be adjusted to mitigate impacts of channel asymmetry.

Calculating the operating current and restraining current based on the first current and voltage measurements 206 and the second current and voltage measurements 210 may be challenging. For example, imbalances in time alignment between the first current and voltage measurements 206 and the second current and voltage measurements 210 may lead to inaccuracies in determinations of the operating current, the restraining current, or other values. Imbalances in time alignment may result from, for example, noise, disruption, degradation, and the like that may cause asymmetry (e.g., a time amount difference) between communication channels used to communicate current values between the IEDs 202 and 204. Time alignment imbalances may also result from the redirection of communications that introduce additional latency.

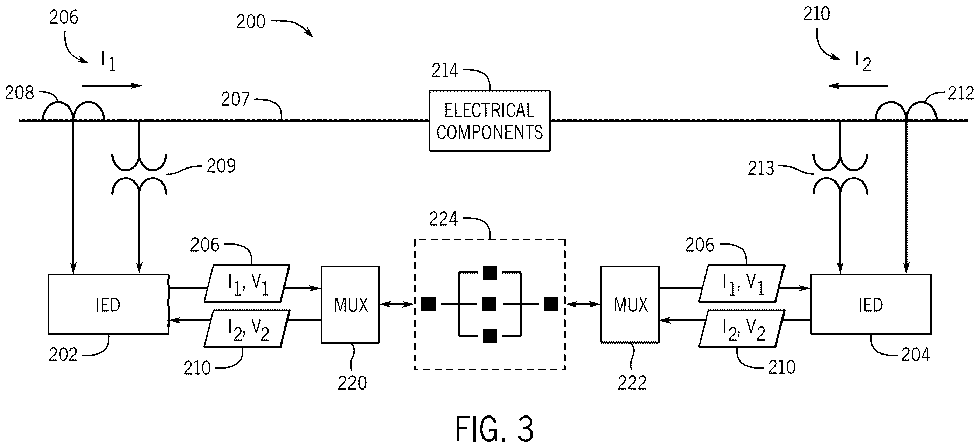

Further, characteristics of communication between the IED 202 and the IED 204 may lead to asymmetry in communication of the first and second current measurements 206 and 210. FIG. 3 illustrates a block diagram of the system 200 in which the IEDs 202 and 204 communicate via a first multiplexer 220, a second multiplexer 222, and a network 224. It should be noted that, while two IEDs are illustrated in FIG. 3, the techniques described herein may be used in systems with more (e.g., 3, 10, 20) IEDs. In the illustrated example, the first multiplexer may combine signals (e.g., data) such as the first current and voltage measurements 206 from the IED 202 along with other data and/or signals that may come from additional components. Likewise, the second multiplexer may combine signals including the second current and voltage measurements 210 from the IED 204 along with other data and/or signals. As illustrated, the multiplexers 220 and 222 may route signals to and from a network 224. The network 224 may include additional multiplexers, networking switches, routers, or other suitable networking components.

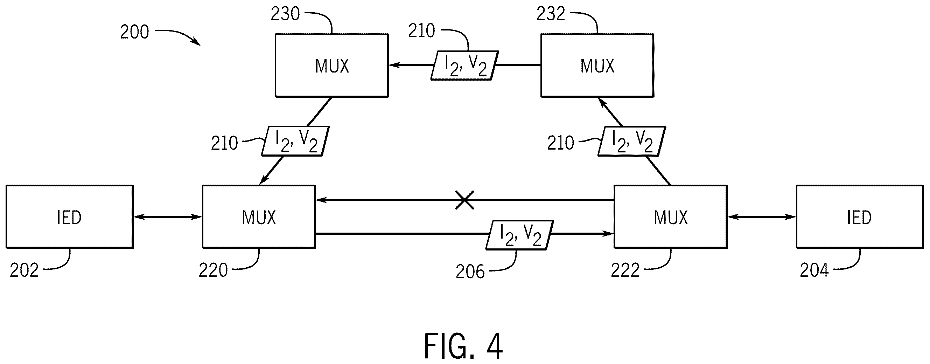

The illustrated implementation may be advantageous for long range transmission of signals, such as the communication of electrical characteristics between IEDs of an expansive electrical grid. For example, if one component of the network 224 fails (e.g., due to a weather event) communications may be redirected along another path within the network 224. However, such redirection may lead to channel asymmetry that may impact the determination of a fault condition as described above. FIG. 4 illustrates the system 200 in which communications between the IED 202 and 204 are redirected (e.g., within the network 224). In the illustrated example, communications sent from the IED 202, such as the first current measurements 206, may be sent to the multiplexer 220, and the multiplexer 220 may route the first current measurements 206 directly to the multiplexer 222 to be routed to the IED 204. Under normal conditions, the second current measurements 210 may be sent from the IED 204 to the multiplexer 222, routed to the multiplexer 220, and sent from the multiplexer 220 to the IED 202. The communications between the multiplexer 220 and the multiplexer 222 may have the same latency in both directions and thus, under normal conditions, channel asymmetry may not be present between the IED 202 and 204.

However, if a portion of the communication pathway between the IED 202 and the IED 204 fails, here illustrated by the broken connection from the multiplexer 222 to the multiplexer 220, communications from the IED 204 to the IED 202 may be redirected. In the illustrated example, the multiplexer 222 may detect that direct communication with the multiplexer 220 has failed, and the second current measurements 210 may be redirected via the multiplexer 232 and the multiplexer 230. The illustrated redirection may ensure that the second current and voltage measurements 210 reaches an intended destination (e.g., the IED 202). However, the redirection may introduce latency that causes asymmetry in the channel, and the asymmetry in the channel may cause pseudo-phase shifts between the first current and voltage measurements 206 and the second current and voltage measurements 210. For example, direct communications between any two of the multiplexers 220, 222, 230, and 232 may be completed in one millisecond in either direction. Thus, under normal conditions, the first current and voltage measurements 206 may be received at the IED 204 at a time proximate or the same as when the second current and voltage measurements 210 is received at the IED 202. If, however, direct communications from the multiplexer 222 and the multiplexer 220 are unavailable, the second current and voltage measurements 210 may arrive at the IED 202 two milliseconds after the first current and voltage measurements 206 is received at the IED 204. Such asymmetry may lead to incorrect determinations of operational currents, restraining currents, and fault conditions by the IED 202 and/or the IED 204.

As may be appreciated, accurate characterization of such channel asymmetry may allow for proper mitigation of potential incorrect determinations in fault detection. The degree of asymmetry (in angular radians) in a communication channel between two IEDs in a 2-terminal configuration (e.g., the IEDs 202 and 204 of the system 200) can be calculated as:

$$[4] \qquad Asym_{12} = \text{angle}\left(\frac{V_{pos_{rem}} - I_{pos_{rem}} * Z_{pos_L}}{V_{pos_{loc}}}\right)$$

where subscript "pos" refers to the positive-sequence quantities, "loc" and "rem" indicate the local and remote IED quantities, and $Z_{pos_L}$ refers to the impedance of the line connecting the two IEDs.

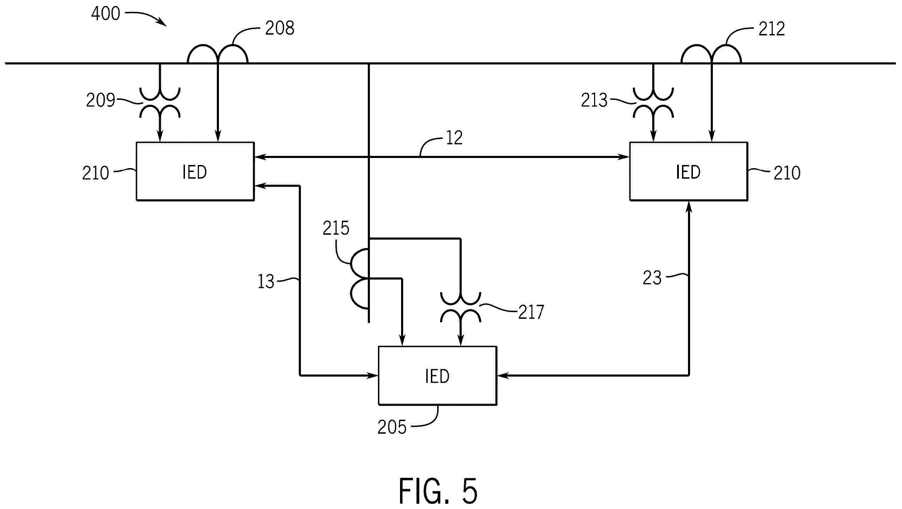

A similar calculation can be used to find asymmetry between any two IEDs in a three-terminal configuration where three IEDs share information with each other via three communication channels. FIG. 5 illustrates a system 400 including an IED 205 in addition to the IEDs 202 and 204 in which the IEDs 202, 204, and 205 communicate current and voltage values. In the illustrated example, the IED 202 may receive first current and voltage measurements from a current transformer 208 and a potential transformer 209, the IED 204 may receive second current and voltage measurements from a second current transformer 212 and a second potential transformer 213, and the IED 205 may receive third current and voltage measurements from a current transformer 215 and a potential transformer 217. In the illustrated example, the IED 202 may communicate with the IED 204 (e.g., a first remote IED) via a first channel 12 and with the IED 205 (e.g., a second remote IED) via a second channel 13. In addition, the IED 205 may communicate with the IED 204 via a third channel 23. The asymmetries in the first channel 12 and the second channel 13 may be calculated as:

$$[5] \qquad Asym_{12} = \text{angle}\left(\frac{V_{pos_{rem1}} - I_{pos_{rem1}} * Z_{pos_{rem1-tap}}}{V_{pos_{loc}} - I_{pos_{loc}} * Z_{pos_{loc-tap}}}\right)$$

$$[6] \qquad Asym_{13} = \text{angle}\left(\frac{V_{pos_{rem2}} - I_{pos_{rem2}} * Z_{pos_{rem2-tap}}}{V_{pos_{loc}} - I_{pos_{loc}} * Z_{pos_{loc-tap}}}\right)$$

where $Z_{pos_{\text{rem1-tap}}}$ refers to the positive-sequence impedance of the line section between the IED 204 and a tap-point (e.g., intersection of the lines connecting the three IEDs), and $Z_{pos_{\text{rem2-tap}}}$ refers to the positive-sequence impedance of the line section between the IED 205 and the tap-point.

Total channel asymmetry, which is a combination of the asymmetry in 2 channels (e.g., the channel 12 and the channel 13) connecting one IED with two other IEDs in a three-terminal configuration, as

$$[7] \qquad Total_{Asym} = \left|\sin\left(\frac{Asym_{12}}{2}\right)\right| + \left|\sin\left(\frac{Asym_{13}}{2}\right)\right|$$

For a two-terminal configuration, where only one channel exists connecting two IEDs, total channel asymmetry is:

$$[8] \qquad Total_{Asym} = \left|\sin\left(\frac{Asym_{12}}{2}\right)\right|$$

Further, for n IEDs, total channel asymmetry may be calculated as:

$$[9] \qquad Total_{Asym} = \sum_{i=0}^{n}\left|\sin\left(\frac{Asym_{1i}}{2}\right)\right|,$$

where $Asym_{li}$ is the asymmetry in a communication channel between a first IED and each remaining n IED.

The total channel asymmetry may be a slope-like quantity which represents the worst-case (i.e. with the current distribution between terminals that is least favorable for 87L security during asymmetry) effect of the channel asymmetry in the percentage differential characteristic. It can be compared directly to a percentage-differential slope to determine if the total asymmetry of the system is large enough to warrant a security measure to prevent an undesired operation. As an example, for a slope k of a percentage-differential protection, to avoid a protection misoperation due to channel asymmetry, the total asymmetry must be less than k, i.e.

$$[10] \qquad Total_{Asym} < k$$

An incremental-quantity based asymmetry evaluation can also be made using fundamental frequency, one-cycle-filtered current or voltages. This method only requires one analog quantity to calculate asymmetry and is faster than the phasor-based method. It uses the difference between the present sample and a one-cycle old sample of the analog and compares this difference to a threshold created from one-cycle old phasor magnitude and a given "asymmetry-check" value to determine if the actual asymmetry is greater than the "asymmetry-check" value. The incremental quantity is calculated as

$$[11] \qquad \Delta Sig(k) = Sig(k) - Sig(k - T)$$

where Sig refers to a generic voltage or current signal received by a local IED from a remote IED via a communication channel, k refers to the present processing interval, and T refers to the fundamental frequency period. The threshold can be calculated as

$$[12] \qquad Threshold(k) = 2 * \sqrt{2} * \left|Sig_{phsr}(k - T)\right| * \sin\left(\frac{2*\pi*f*asym_{check}}{2}\right)$$

where $Sig_{phsr}$ refers to the phasor created from Sig, |.| denotes the absolute magnitude of a quantity, f refers to the fundamental frequency, and $asym_{check}$ refers to the asymmetry-check value. The asymmetry is declared to be higher than asymmetry check value if the incremental quantity becomes higher than the threshold within a one-cycle time period of fundamental frequency.

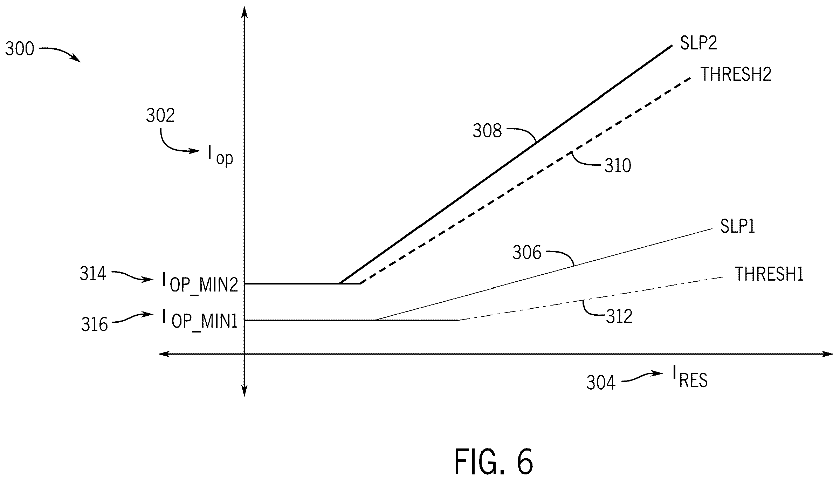

FIG. 6 illustrates a graphical representation of the relationship 300 between restraining current 304 and operating current 302 including several threshold relationships, some of which represent operational thresholds and some of which represent boundary conditions for switching between operational thresholds. As illustrated, the relationship includes a first operating mode 306 that may be defined by a first k value (e.g., slope value) and a second operating mode 308 that may be defined by a second k value. The first operating mode 306 may be implemented by an electric power delivery system during normal operating conditions (e.g., when no fault condition is detected), and the second operating mode 308 may be implemented when a external fault condition or channel asymmetry condition is detected. In the illustrated example, a first operating current minimum 316 may define a minimum operating current for the first operating mode 306, and a second operating current minimum 323 may define a minimum operating current for the second operating mode 308. Additionally, a first threshold 312 and a second threshold 310 may be used to evaluate a channel asymmetry condition. In the illustrated example, the first threshold 312 may have a slope that is 70% of the slope of the first operating mode 306, and the second threshold 310 may have a slope that is 80% of the second operating mode 308.

Total asymmetry (e.g., as determined in equation 9) may be compared to the first threshold 312, the second threshold 310, the first operating mode 306, and the second operating mode 308 secure line differential protection for a channel asymmetry condition. For example, the IED 202 and/or the IED 204 may, based on the comparison, perform a control function, such as adjusting the k value such that an operating mode is changed or blocking line current differential functions. Additionally, control functions may be performed based on the presence of an external fault (e.g., a fault along an electrical line outside of an area measured by two or more IEDs). Control functions may be performed by an IED based on a comparison between total asymmetry and the above relationships as follows:

Table 1. Asymmetry and Control Functions

| Total Asymmetry | EFD | Line Current Differential Protection Action |
| --- | --- | --- |
| $Asym_{Total} <$ Thresh1 | 0 | No action |
| $Asym_{Total} <$ Thresh1 | 1 | Switch to slope 2 |
| Thresh1 $< Asym_{Total} <$ Slp1 | 0/1 | Switch to slope 2 |
| Slp1 $< Asym_{Total} <$ Thresh2 | 0 | Switch to slope 2 |
| Slp1 $< Asym_{Total} <$ Thresh2 | 1 | Block line current differential protection function |
| Thresh2 $< Asym_{Total}$ | 0/1 | Block line current differential protection function |

The EFD indicator may indicate whether an external fault (e.g., a fault outside of a portion of an electrical line monitored by two or more IEDs) is present. For example, an external fault may cause saturation of one or more current transformers used to measure currents used by one or more IEDs to detect faults, and may thus indicate that anomalous current measurements may not be the result of a fault between current transformers. An external fault may be detected by, for instance, additional IEDs, current transformers, and the like coupled to an electrical line outside of a portion of the electrical line monitored by one or more IEDs (e.g., the IED 202 and/or the IED 204). As shown, when total asymmetry is below the first threshold 312 and no external fault is detected, one or more IEDs may not take responsive action. If, however, total asymmetry is below the first threshold 312 and an external fault is detected (EFD = 1), one or more IEDs may alter the k value such that the second operating mode 308 is established.

Similarly, if the total asymmetry is between the first threshold 312 and the first operating mode 306, one or more IEDs may alter the k value such that the second operating mode 308 is established (e.g., regardless of whether an external fault is detected). If the total asymmetry is between the first operating mode 306 and the second threshold 310 and an external fault is not detected, the k value may be altered such that the second operating mode 308 is established. If, however, the total asymmetry is between the first operating mode 306 and the second threshold 310 and an external fault is detected, one or more IEDs may block line current differential protection. Likewise, it the total asymmetry is greater than the second threshold 310, one or more IEDs may block line current differential protection regardless of whether an external fault is detected.

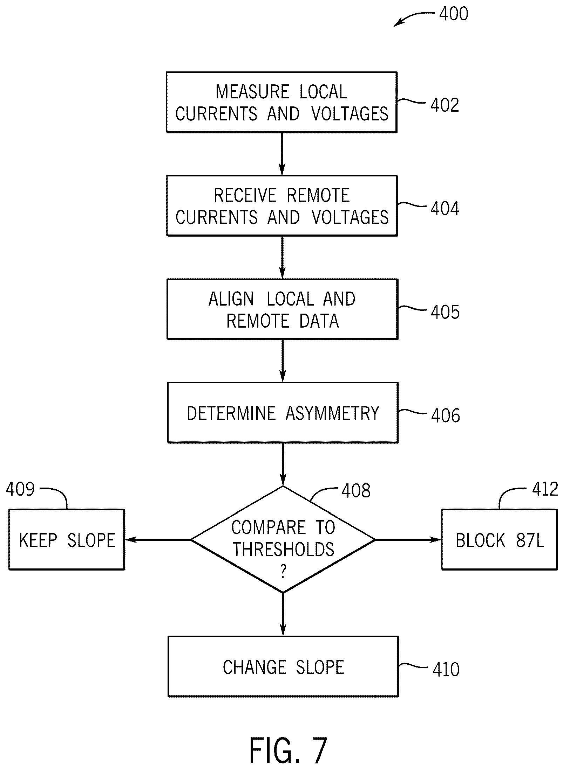

FIG. 7 illustrates a flow chart of a method 400 for evaluating and mitigating a channel asymmetry condition that may be performed by an IED of an electric power delivery system. The method 400 may begin, in block 402, with measuring local currents and voltages along an electrical line. This may be performed in conjunction with a current transformer and a voltage transformer as discussed above. For example, the IED 202 of FIGS. 2-4 may receive the first current and voltage measurements 206 as measured by the current transformer 208. In block 404, a remote current measurement is received at the IED. The remote current measurement may be received, as described herein, via communication channels that may include multiplexers (e.g., the multiplexers 220 and 222 of FIGS. 3-4) and/or additional components of a network (e.g., the network 224). In block 406, total asymmetry may be determined by an IED according to equation 9 based on estimated asymmetry in one or more communication channels . In block 405, the local data (e.g., the locally measured currents and voltages) and the remote data (e.g., the received current and voltage measurements) may be time-aligned.

The IED may then, in block 408, compare the total asymmetry determined in block 406 to one or more thresholds, as shown in table 1. Each threshold, as described herein, may include a relationship between an operating current and a restraining current with a slope defined by an adjustable k value, and may include one or more operating modes. Based on the comparison, the IED may determine that the slope should be unchanged in block 409. Additionally or alternatively, the IED may determine that a new operating mode with a different k value should be implemented, as illustrated by block 410. Finally, the IED may, based on the comparison between the total asymmetry and the thresholds, determine that functions of the line current differential protection system should be blocked, as represented by block 412.

While specific embodiments and applications of the disclosure have been illustrated and described, it is to be understood that the disclosure is not limited to the precise configurations and components disclosed herein. For example, the systems and methods described herein may be applied to an industrial electric power delivery system or an electric power delivery system implemented in a boat or oil platform that may or may not include long-distance transmission of high-voltage power. Accordingly, many changes may be made to the details of the above-described embodiments without departing from the underlying principles of this disclosure. The scope of the present disclosure should, therefore, be determined only by the following claims.

Indeed, the embodiments set forth in the present disclosure may be susceptible to various modifications and alternative forms, specific embodiments have been shown by way of example in the drawings and have been described in detail herein. However, it may be understood that the disclosure is not intended to be limited to the particular forms disclosed. The disclosure is to cover all modifications, equivalents, and alternatives falling within the spirit and scope of the disclosure as defined by the following appended claims. In addition, the techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for [perform]ing [a function]..." or "step for [perform]ing [a function]...", it is intended that such elements are to be interpreted under 35 U.S.C. 112(f). For any claims containing elements designated in any other manner, however, it is intended that such elements are not to be interpreted under 35 U.S.C. 112(f).

## Claims

1. A system, comprising:
   a first intelligent electronic device (IED) of an electric power delivery system, wherein the first intelligent electronic device (IED) is configured to:

   receive a local current measurement of a local current and a local voltage measurement of a local voltage along an electrical line;
   transmit a first signal indicative of the local current measurement and the local voltage measurement to one or more additional intelligent electronic devices (IEDs) via one or more communication channels;
   receive one or more additional signals indicative of remote current measurements and remote voltage measurements from each of the additional intelligent electronic devices (IEDs) via the one or more communication channels;
   determine a respective asymmetry of each of the one or more communication channels based on the local current measurement, the local voltage measurement, the remote current measurements, and the remote voltage measurements;
   determine a total asymmetry based on the respective asymmetries;
   compare the total asymmetry to one or more threshold relationships between operating currents and restraining currents, each of the one or more threshold relationships comprising a slope value; and
   perform a control function based on the comparison.

2. The system of claim 1, wherein the control function comprises blocking a line current differential protection function of the first intelligent electronic device (IED).

3. The system of claim 1, wherein the respective asymmetry of each of the one or more communication channels is determined as:

$$Asym \;\; = \text{angle}\left(\frac{V_{pos_{rem}} - I_{pos_{rem}} * Z_{pos_{rem-tap}}}{V_{pos_{loc}} - I_{pos_{loc}} * Z_{pos_{loc-tap}}}\right)$$

Where $V_{pos_{rem}}$ is a positive-sequence of the remote voltage measurements, $I_{pos_{rem}}$ is a positive-sequence of the remote current measurements, $Z_{pos_{rem-tap}}$ and $Z_{post_{loc-tap}}$ are positive-sequences of an impedance of the one or more communication channels, and $V_{pos_{loc}}$ is a positive sequence of the local voltage measurement, and $I_{pos_{loc}}$ is a positive-sequence of the local current measurement.

4. The system of claim 3, wherein the total asymmetry is determined as:

$$Total_{Asym} = \sum_{i=0}^{n} \left|\sin\left(\frac{Asym}{2}\right)\right|.$$

5. The system of claim 1, wherein the total asymmetry comprises a slope quantity able to be compared to the one or more threshold relationships.

6. The system of claim 5, wherein the slope quantity represents a worst-case effect of the total asymmetry on the electric power delivery system.

7. The system of claim 1, wherein one or more of the respective asymmetries comprise a time amount.

8. The system of claim 1, wherein the control function comprises entering a new operating mode causing the one or more threshold relationships to change.

9. The system of claim 1, wherein the local current measurement is received from a current transformer coupled to the electrical line and the local voltage measurement is received from a voltage transformer coupled to the electrical line.

10. A method, comprising:

   receiving a local current measurement of a first current and a local voltage measurement along an electrical line;
   transmitting a first signal indicative of the local current measurement and the local voltage measurement to an intelligent electronic device (IED) of an electric power delivery system via a first communication channel;
   receiving a second signal indicative of a remote current measurement of a second current and a remote voltage measurement of a second voltage along the electrical line from the intelligent electronic device (IED) via a second communication channel;
   determining a total asymmetry based on a first asymmetry of the first communication channel and a second asymmetry of the second communication channel;
   comparing the total asymmetry to one or more threshold relationships between operating currents and restraining currents of the electrical line, each of the one or more threshold relationships comprising a slope; and
   performing a control function based on the comparison.

11. The method of claim 10, wherein a first threshold relationship of the one or more threshold relationships corresponds to a first operating mode and a second threshold relationship of the one or more threshold relationships corresponds to a second operating mode, and wherein a first slope of the first threshold relationship is less than a second slope of the second threshold relationship.

12. The method of claim 11, wherein a third threshold relationship of the one or more threshold relationships comprises a slope that is 80% of the first threshold relationship, and wherein a fourth threshold relationship of the one or more threshold relationships comprises a slope that is 70% of the second threshold relationship.

13. The method of claim 12, comprising:
   receiving an indication of whether an external fault is present along the electrical line, wherein the control function is performed based on the comparison and the indication of the external fault.

14. The method of claim 13, wherein the control function comprises entering a new operating mode causing the one or more threshold relationships to change.

15. The method of claim 14, wherein the control function is performed in response to the total asymmetry being less than the third threshold relationship and the external fault being indicated, the total asymmetry being between the third threshold relationship and the first threshold relationship, or the total asymmetry being between the first threshold relationship and the fourth threshold relationship and the external fault not being indicated.

FIG. 1

FIG. 2

FIG. 3

EP 4 749 860 A1

FIG. 4

FIG. 5

FIG. 6

400

```
┌─────────────────────────┐
│    MEASURE LOCAL        │── 402
│ CURRENTS AND VOLTAGES   │
└─────────────────────────┘
            │
            ▼
┌─────────────────────────┐
│    RECEIVE REMOTE       │── 404
│ CURRENTS AND VOLTAGES   │
└─────────────────────────┘
            │
            ▼
┌─────────────────────────┐
│    ALIGN LOCAL AND      │── 405
│    REMOTE DATA          │
└─────────────────────────┘
            │
            ▼
┌─────────────────────────┐
│   DETERMINE ASYMMETRY   │── 406
└─────────────────────────┘
            │
            ▼
```

409 ─┐                        ┌─ 408                        412 ─┐

┌─────────────┐         ◇ COMPARE TO ◇         ┌─────────────┐
│ KEEP SLOPE  │ ◄────── ◇ THRESHOLDS ◇ ──────► │  BLOCK 87L  │
└─────────────┘         ◇     ?     ◇          └─────────────┘
                              │
                              ▼
                    ┌─────────────────┐
                    │  CHANGE SLOPE   │── 410
                    └─────────────────┘

## FIG. 7

Europäisches
Patentamt

European
Patent Office

Office européen
des brevets

## EUROPEAN SEARCH REPORT

**Application Number**

EP 25 21 7856

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2017/059636 A1 (KERGER TORSTEN [DE] ET AL) 2 March 2017 (2017-03-02) | 1-11 | INV.<br>H02H3/28 |
| A | * paragraphs [0026], [0050] - [0110]; figures 1-3 * | 12-15 | H02H7/26<br>H02H1/00<br>H04B17/00 |
| Y | WU YINGJUN ET AL: "Risk evaluation model for relay protection considering communication delay and bit error", 2014 CHINA INTERNATIONAL CONFERENCE ON ELECTRICITY DISTRIBUTION (CICED), IEEE, 23 September 2014 (2014-09-23), pages 360-363, XP032711361, DOI: 10.1109/CICED.2014.6991729 [retrieved on 2014-12-18] | 1-11 | ADD.<br>H02H3/05 |
| A | * equations 5-6; page 1, columns 3-4 - page 2 * | 12-15 | |
| Y | LI MANLI ET AL: "False-tirp probability model for the current differential protection considering power grid operation state and communication delay", 2015 5TH INTERNATIONAL CONFERENCE ON ELECTRIC UTILITY DEREGULATION AND RESTRUCTURING AND POWER TECHNOLOGIES (DRPT), IEEE, 26 November 2015 (2015-11-26), pages 2512-2516, XP032881085, DOI: 10.1109/DRPT.2015.7432676 [retrieved on 2016-03-11] | 1-11 | TECHNICAL FIELDS SEARCHED (IPC)<br><br>H02H<br>H04B |
| A | * sections II and III * | 12-15 | |
| A | US 8 791 730 B2 (LI YOUYI [CN]; SU BIN [CN] ET AL.) 29 July 2014 (2014-07-29) * equations 12-14; columns 6-7 * | 3 | |

-/--

The present search report has been drawn up for all claims

| Place of search | Date of completion of the search | Examiner |
|---|---|---|
| Munich | 13 March 2026 | Gomes Guerreiro, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**page 1 of 2**

Europäisches
Patentamt

European
Patent Office

Office européen
des brevets

# EUROPEAN SEARCH REPORT

**Application Number**

EP 25 21 7856

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | GB 2 625 495 A (NR ELECTRIC CO LTD [CN]; NR ENGINEERING CO LTD [CN]) 19 June 2024 (2024-06-19) * pages 10-16; figures 1-5 * ----- | 1,10 | |
| A | US 2023/077975 A1 (SALJ JOHAN [SE]) 16 March 2023 (2023-03-16) * paragraphs [0063] - [0076]; figures 1-5 * ----- | 1,10 | |

TECHNICAL FIELDS
SEARCHED     (IPC)

The present search report has been drawn up for all claims

| Place of search | Date of completion of the search | Examiner |
|---|---|---|
| Munich | 13 March 2026 | Gomes Guerreiro, G |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

                                               
& : member of the same patent family, corresponding
    document

EPO FORM 1503 03.82 (P04C01)

# EP 4 749 860 A1

## ANNEX TO THE EUROPEAN SEARCH REPORT
## ON EUROPEAN PATENT APPLICATION NO.

EP 25 21 7856

This annex lists the patent family members relating to the patent documents cited in the above-mentioned European search report.
The members are as contained in the European Patent Office EDP file on
The European Patent Office is in no way liable for these particulars which are merely given for the purpose of information.

13-03-2026

| Patent document cited in search report | | Publication date | Patent family member(s) | | Publication date |
|---|---|---|---|---|---|
| US 2017059636 | A1 | 02-03-2017 | EP | 3136528 A1 | 01-03-2017 |
| | | | US | 2017059636 A1 | 02-03-2017 |
| US 8791730 | B2 | 29-07-2014 | CN | 103201923 A | 10-07-2013 |
| | | | EP | 2638611 A1 | 18-09-2013 |
| | | | RU | 2524383 C1 | 27-07-2014 |
| | | | US | 2013181755 A1 | 18-07-2013 |
| | | | WO | 2012061978 A1 | 18-05-2012 |
| GB 2625495 | A | 19-06-2024 | CL | 2024000998 A1 | 19-07-2024 |
| | | | CN | 114050559 A | 15-02-2022 |
| | | | GB | 2625495 A | 19-06-2024 |
| | | | WO | 2023087943 A1 | 25-05-2023 |
| US 2023077975 | A1 | 16-03-2023 | AU | 2021213406 A1 | 08-09-2022 |
| | | | CN | 115004507 A | 02-09-2022 |
| | | | EP | 3859926 A1 | 04-08-2021 |
| | | | EP | 4097817 A1 | 07-12-2022 |
| | | | JP | 7493041 B2 | 30-05-2024 |
| | | | JP | 2023512265 A | 24-03-2023 |
| | | | US | 2023077975 A1 | 16-03-2023 |
| | | | WO | 2021151909 A1 | 05-08-2021 |

EPO FORM P0459

For more details about this annex : see Official Journal of the European Patent Office, No. 12/82